(19) Europäisches Patentamt
European Patent Office
Office européen des brevets

(11) **EP 3 346 689 A1**

(12) **EUROPEAN PATENT APPLICATION**

(43) Date of publication:
**11.07.2018 Bulletin 2018/28**

(51) Int Cl.:
*H04N 1/58* (2006.01)          *B33Y 10/00* (2015.01)
*B33Y 50/02* (2015.01)

(21) Application number: **17167583.8**

(22) Date of filing: **21.04.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **05.01.2017   TW 106100319**

(71) Applicants:
• **XYZprinting, Inc.
New Taipei City 22201 (TW)**

• **Kinpo Electronics, Inc.
New Taipei City 22201 (TW)**

(72) Inventors:
• **SHIH, Ko-Wei
22201 Shenkeng Dist., New Taipei City (TW)**
• **YUAN, Kuo-Yen
22201 Shenkeng Dist., New Taipei City (TW)**

(74) Representative: **2K Patentanwälte Blasberg
Kewitz & Reichel
Partnerschaft mbB
Schumannstrasse 27
60325 Frankfurt am Main (DE)**

(54) **METHOD FOR COMPENSATING COLOR OF COLORED 3D OBJECT**

(57)     A method for compensating color of colored 3D object includes following steps: importing a 3D object (4); performing an object slicing process to the 3D object (4) for generating multiple object printing-route information for multiple printing layers; performing an image slicing process to the 3D object (4) for generating multiple color printing information for the multiple printing layers; performing a compensation process to each color printing information for generating updated color printing information, each of the updated color printing information compensates the color of an oblique face (5) of the 3D object (4) which has an oblique angle within a specific range.

FIG.3A

EP 3 346 689 A1

FIG.3B

**Description**

1. Technical Field

The technical field relates to a colored 3D object, and specifically relates to a method for compensating color of the colored 3D object.

2. Description of Related Art

Due to the maturity of the development of 3D printing technology and also the narrowed size and dropped price of the current 3D printers, the 3D printers are growing and becoming popular very quick these years. Additionally, for making the printed 3D models more acceptable to the users, parts of the manufacturers have brought new types of 3D printers to the market that can print colored 3D models.

When performing printing through the aforementioned 3D printer, it first prints materials to constitute object blocks, then jets different colors of inks right on the object blocks, so as to perform coloring to the object blocks. Therefore, a full-colored 3D model can be made and stacked through multiple colored object blocks.

Though the 3D printers can print any shapes of 3D models, however, the 3D printers jet the color ink vertically from the top right through the bottom, if any 3D model comprises a face which is downward tilted, the face is difficult to be colored by the 3D printer.

Accordingly, if one face of any 3D model is downward tilted, the aforementioned object block corresponding to that face may have a downward tilted angle as well. When performing coloring to the object block, only upper half of the object block can be moistened by the ink jetted by the 3D printer. As a result, the completed color of the object block will be lighter than the actual color needed for the 3D model.

Furthermore, according to the existence of the tilted angle, the 3D printer may perform uneven coloring on the object block, so as to affect the exterior of the full-colored 3D model.

SUMMARY OF THE INVENTION

The invention is directed to a method for compensating color of colored 3D object, which may perform compensation on the color of one or more faces upon a 3D object that have a specific oblique angle.

In one of the exemplary embodiments, the method of the present application comprises following steps of: importing a 3D object; performing an object slicing process to the 3D object for generating multiple object printing-route information for multiple printing layers; performing an image slicing process to the 3D object for generating multiple color printing information for the multiple printing layers; performing a compensation process to each color printing information for generating updated color printing information, wherein each of the updated color printing information has been compensated one the color of an oblique face of the 3D object which has an oblique angle within a specific range

Therefore, when printing a physical 3D model, a 3D printer may control a 3D nozzle to print multiple slicing objects corresponding to multiple printing layers in order according to the multiple printing-route information, and controls a 2D nozzle to perform coloring to each slicing object of each printing layer respectively according to the multiple updated color printing information.

In comparison with related art, each embodiment disclosed in the present invention may perform compensation on the color of each tilted face of the 3D object, so as to prevent the 3D object from being colored lighter or uneven due to the downward tilted face(s) which is hard to be colored.

BRIEF DESCRIPTION OF THE DRAWINGS

Fig. 1 is a schematic view of a 3D printer according to one embodiment of the present disclosure.
Fig. 2 is a flowchart for slicing and printing according to one embodiment of the present disclosure.
Fig. 3A is a schematic view of a first oblique face according to one embodiment of the present disclosure.
Fig. 3B is a schematic view of a second oblique face according to one embodiment of the present disclosure.
Fig. 4 is a schematic view of a 3D object.
Fig. 5 is a schematic view of an oblique angle according to one embodiment of the present disclosure.
Fig. 6 is a color compensating flowchart according to one embodiment of the present disclosure.

DETAILED DESCRIPTION OF THE INVENTION

In cooperation with the attached drawings, the technical contents and detailed description of the present invention are described thereinafter according to multiple embodiments, being not used to limit its executing scope. Any equivalent variation and modification made according to appended claims is all covered by the claims claimed by the present invention.

This invention discloses a method for compensating color of colored 3D object (refers to as the method hereinafter), the method is mainly adopted by a 3D printer that arranged with a nozzle for jetting a material and other nozzle for jetting colored ink and the 3D printer may print full-colored 3D models through the nozzles.

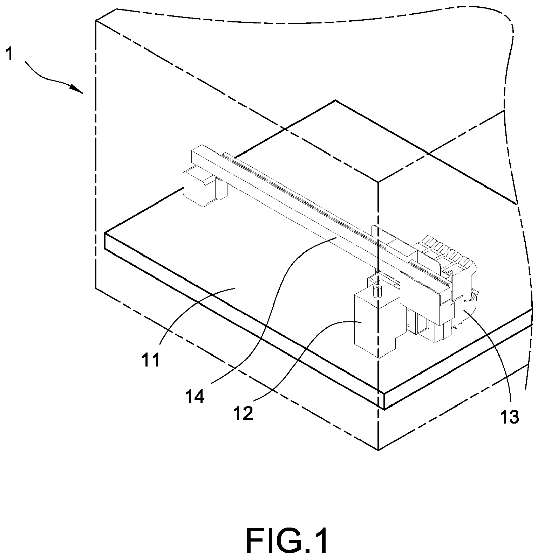

Fig. 1 is a schematic view of a 3D printer according to one embodiment of the present disclosure. The embodiment of Fig. 1 discloses a certain type of 3D printer (refers to as the printer 1 hereinafter), the printer 1 comprises a printing platform 11, and comprises, upon the printing platform 11, a 3D nozzle 12 for jetting a material in order to print 3D objects, and a 2D nozzle 13 for jetting different colors of inks in order to perform coloring on the printed 3D objects.

In one embodiment, the 2D nozzle 13 may be the ink nozzle adopted by current 2D printers (or called plane printers), which comprises or connects with multiple ink cartridges storing different colors of inks. In the embodiment, the 2D nozzle 13 may connect with at least four ink cartridges, which respectively store Cyan ink, Magenta ink, Yellow ink, and Black ink, but not limited thereto.

In the embodiment of Fig. 1, the printer 1 is illustrated with a fused deposition modeling (FDM) 3D printer, which the 3D nozzle 12 of the printer 1 adopts a thermoplastic filament as the material.

In the embodiment of Fig. 1, the 3D nozzle 12 and the 2D nozzle 13 are arranged at same control stick 14 of the printer 1. In particular, the 3D nozzle 12 and the 2D nozzle 13 are arranged respectively on two opposite faces of one end of the control stick 14, and the printer 1 may control the 3D nozzle 12 and the 2D nozzle 13 to move through controlling the control stick 14. In another embodiment, the printer 1 may comprise multiple control sticks, and uses different control sticks to arrange and control the 3D nozzle 12 and the 2D nozzle 13 alternatively.

When perform printing, the printer 1 may control the 3D nozzle 12 to print, layer-by-layer, each slice object corresponding to each printing layer of a colored 3D object upon the printing platform 11, and may control the 2D nozzle 13 to perform coloring on each printed slice object. In an embodiment, the 2D nozzle 13 may perform coloring on the contour of each slice object.

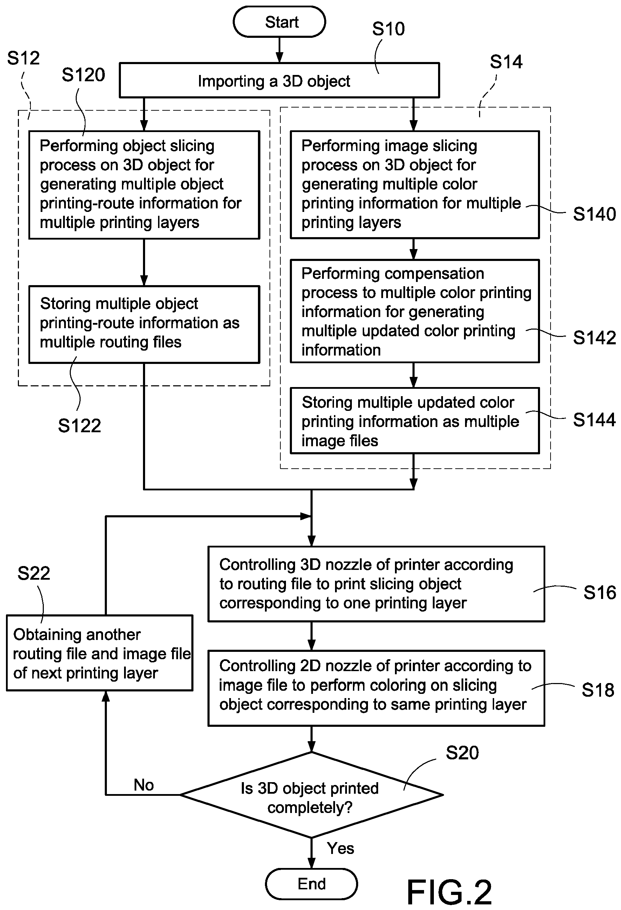

Fig. 2 is a flowchart for slicing and printing according to one embodiment of the present disclosure. The embodiment of Fig. 2 discloses multiple compensating steps, wherein the compensating steps are executed by the printer 1 or a processor of a computer (not shown) connected with the printer 1 for performing a color compensation process. Also, the embodiment of Fig. 2 discloses multiple printing steps, wherein the printing steps are executed by the printer 1 for performing printing a 3D object and coloring on the 3D object according to compensated information.

First, a 3D object is imported by the printer 1 or the processor of the computer (step S10). In the embodiment, the 3D object may be a completely-edited 3D object. If the printer 1 performs printing according to the 3D object, the printer 1 may print a physical full-colored 3D model.

After the importation of the 3D object, the processor may then respectively perform a 3D object processing procedure (step S12) and a 2D image processing procedure (step S14) on the 3D object. In one embodiment, the processor may perform the 3D object processing procedure or the 2D image processing procedure first alternatively. In another embodiment, the processor may adopt a multiplexer and performs the 3D object processing procedure and the 2D image processing procedure simultaneously.

During the aforementioned 3D object processing procedure, the processor performs an object slicing process on the 3D object, so as to generate multiple object printing-route information for multiple printing layers of the 3D object (step S120). The amount of the multiple object printing-route information equals to the amount of the multiple printing layers of the 3D object, i.e., each printing layer of the 3D object has a corresponding one of object printing-route information.

Next, the processor stores the multiple object printing-route information as multiple routing files (step S122), wherein each of the routing files corresponds to one of the printing layers. In one embodiment, the processor stores the multiple routing files to a storing unit of the printer 1 or the computer. In another embodiment, the processor stores the multiple routing files to a portable storage through a connect port. In another embodiment, the processor stores the multiple routing files to a cloud database through the Internet.

During the 2D image processing procedure, the processor performs an image slicing process on the 3D object, so as to generate multiple color printing information for the multiple printing layers of the 3D object (step S140). The amount of the multiple color printing information equals to the amount of the multiple printing layers, i.e., each printing layer of the 3D object has a corresponding one of color printing information.

In one embodiment, the amount of the multiple color printing information equals to the amount of the multiple object printing-route information as well, in other words, each printing layer of the 3D object has a corresponding one of the object printing-route information and a corresponding one of the color printing information.

After step S140, the processor performs a compensation process to the multiple color printing information, so as to generate multiple updated color printing information (step S142). In this embodiment, each of the updated color printing information has been compensated on the color of one or more oblique faces of the 3D object. More specific, each of the updated color printing information has been compensated one the color of one or more oblique faces which are downward tilted of the 3D object.

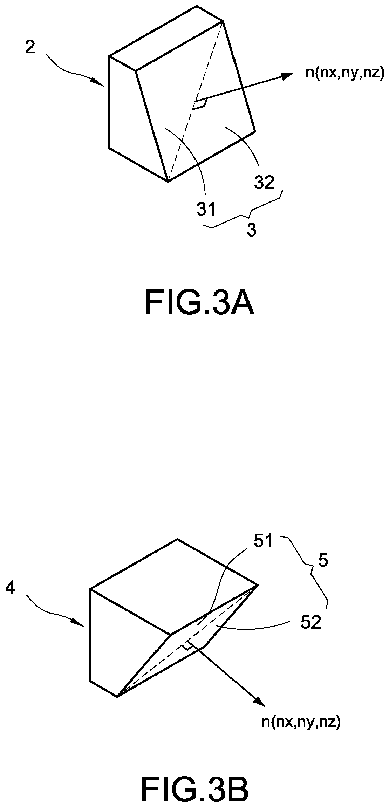

In one embodiment, the aforementioned oblique face may have an oblique angle that is within a specific range. In other words, the 3D object may comprise multiple oblique faces, some of which having an oblique angle(s) outside the specific range will not be compensated by the processor in their corresponding color printing information, and the others having an oblique angle(s) within the specific range (like an oblique face 5 as shown in Fig. 3B) will be compensated by the processor in their corresponding color printing information.

After step S142, the processor stores the multiple updated color printing information as multiple image files to the storing unit, the portable storage or the database (step S144), wherein each of the image files respectively corresponds to one of the printing layers.

Fig. 3A is a schematic view of a first oblique face according to one embodiment of the present disclosure. The embodiment of Fig. 3A discloses a 3D object 2, which comprises multiple faces thereon. The following description will be discussed by using a first oblique face 3 of the 3D object 2.

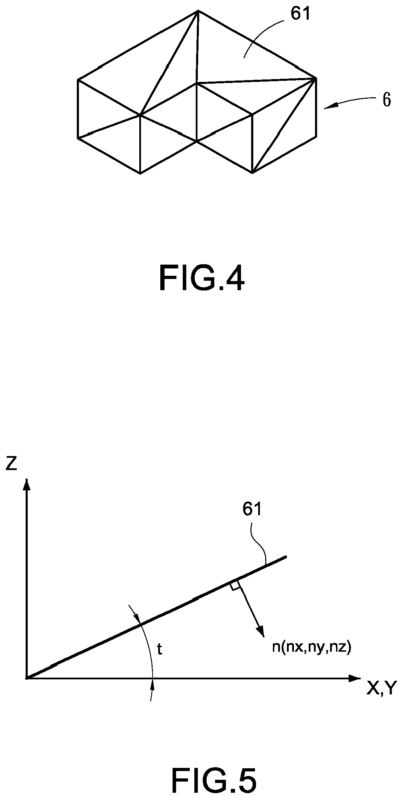

Please refer to Fig. 4 simultaneously, which is a schematic view of a 3D object. The embodiment of Fig. 4 discloses a 3D object 6. In the view of the processor, the contours of the 3D object 6 are constituted by multiple triangular faces 61, i.e., the contours and the color of the 3D object 6 are all determined with respect to the settings of the triangular faces 61 of the 3D object 6. The technical feature corresponding to the triangular faces is a well-known technology in the art of 3D drawing, no more discussion is needed.

In the embodiment of Fig. 3A, the first oblique face 3 is constituted by a first triangular face 31 and a second triangular face 32, in other words, the color of the first oblique face 3 is determined by the first triangular face 31 and the second triangular face 32. Additionally, the embodiment of Fig. 3A shows a normal vector n(nx,ny,nz) which is perpendicular to the first oblique face 3, and the normal vector n of the first oblique face 3 is upward oriented (it means that the first oblique face 3 is a upward tilted face).

Due to the upward-oriented normal vector of the first oblique face 3, the printer 1 may not cause a problem when performing coloring on the first oblique face 3 (for example, the first oblique face 3 is not hard to be colored, so the color of the first oblique face 3 may not be colored slight or uneven). In this embodiment, the first oblique face 3 is not deemed as a need-to-adjust oblique face of the 3D object 2, the processor will not perform color compensation on the color printing information related to the first oblique face 3 in aforementioned step S142.

Fig. 3B is a schematic view of a second oblique face according to one embodiment of the present disclosure. The embodiment of Fig. 3B discloses another 3D object 4, which comprises multiple faces thereon. The following description will be discussed by using a second oblique face 5 of the 3D object 4.

In the embodiment of Fig. 3B, the second oblique face 5 is constituted by a third triangular face 51 and a fourth triangular face 52, in other words, the color of the second oblique face 5 is determined by the third triangular face 51 and the fourth triangular face 52. Additionally, the embodiment of Fig. 3B shows another normal vector n(nx,ny,nz) which is perpendicular to the second oblique face 5, and the normal vector n of the second oblique face 5 is downward oriented (it means that the second oblique face 5 is a downward tilted face).

Due to the downward-oriented normal vector of the second oblique face 5, the printer 1 may cause a problem when performing coloring on the second oblique face 5 (specifically, the second oblique face 5 is hard to be colored, so the color of the second oblique face 5 may be colored uneven, or may be slighter than the correct color). In this embodiment, the aforementioned second oblique face 5 is deemed as a need-to-adjust oblique face of the 3D object 4. Accordingly, the processor will perform color compensation on the color printing information related to the second oblique face 5 in aforementioned step S142.

More specifically, in the embodiment of the present disclosure, any face that has a downward-oriented normal vector of a 3D object will be deemed as a need-to-adjust oblique face by the processor, and will be performed with color compensation when the processor performs the image slicing process.

Fig. 5 is a schematic view of an oblique angle according to one embodiment of the present disclosure. In one embodiment, the processor compares a triangular face 61 with a plane that constituted by an X axis and a Y axis for determining an oblique angle t of the triangular face 61, wherein an angle of the plane is deemed as 0 degree.

In the embodiment of Fig. 5, a Z axis is perpendicular to the plane that constituted by the X axis and the Y axis, and an angle of the Z axis is 90 degrees $\left(\text{i.e., } \frac{\pi}{2}\right)$. In this embodiment, the aforementioned specific range may be set as a range that is bigger than 0 degree and smaller than 90 degrees.

In another embodiment, the processor may preset a tolerance (such as 3 degrees, 5 degrees, etc.) according to the printing accuracy of the printer 1 to be used. In particular, if the printer 1 has high printing accuracy, it won't face a hard-to-coloring problem within a tolerance range of 3 degrees to 5 degrees. Accordingly, the specific range in this embodiment may be set as a range that is bigger than 3 degrees and smaller than 87 degrees, or set as another range that is bigger than 5 degrees and smaller than 85 degrees, but not limited thereto.

Please refer back to Fig. 3. After step S12 and step S14, the processor has completed the slicing procedure and the color compensation procedure for the 3D object.

When performing printing, the printer 1 may obtain one of the routing files from the storing unit, the portable storage or the database, and controls the 3D nozzle 12 of the printer 1 according to the routing file to print the slicing object corresponding to one of the printing layers (such as a first layer) (step S16).

Additionally, the printer 1 may obtain one of the image files from the storing unit, the portable storage or the database as well, and controls the 2D nozzle 13 according to the image file during the printing of the slicing object, so as to perform coloring on the slicing object of same printing layer (step S18). In particular, when performing coloring, the printer 1 controls the amount of the ink jetted by the 2D nozzle 13 according to the color printing information or the updated color printing information recorded in the image file, so as to adjust the color of each coloring point on the slicing object.

After the slicing object of one printing layer has printed and colored completely, the printer 1 determines whether a full-colored 3D model corresponding to the 3D object is printed completely or not (step S20), i.e., the printer 1 determines whether the printing action and the coloring action for all printing layers of the 3D object are completed. If the full-colored 3D model is not completed yet (i.e., the current printing layer is not a last printing layer of the 3D object), the printer 1 will then obtain another one of the routing files and another one of the image files of the next printing layer (step S22), and re-executes step S16 and step S18, so as to perform the printing action and the coloring action for the next printing layer, until the full-colored 3D model has been printed completely.

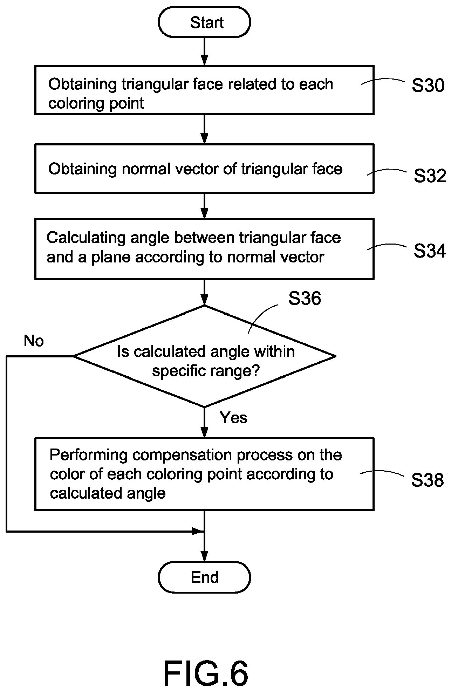

Fig. 6 is a color compensating flowchart according to one embodiment of the present disclosure. In particular, Fig. 6 discloses how the compensation process is performed in step S140 of Fig. 2.

First, the processor obtains the color printing information, and then obtains respectively a triangular face related to each coloring point of the 3D object (step S30), and then respectively obtains a normal vector of each triangular face (step S32). In the following description, only the multiple coloring points on a same oblique face are used to discuss, wherein the multiple coloring points are belonging to same triangular face.

After step S32, the processor calculates an angle between the triangular face and the plane according to the normal vector (step S34), wherein the calculated angle equals to the oblique angle of the oblique face (i.e., the aforementioned oblique angle t).

Additionally, the normal vector of the triangular face may be: n(nx,ny,nz), and the processor calculates the angle according to an angle calculation formula, where the angle calculation formula may be:

$$\cos^{-1}\left(\frac{|nz|}{\sqrt{nx^2+ny^2+nz^2}}\right).$$

Next, the processor determines whether the calculated angle is within the default specific range or not (step S36), i.e., the processor determines the oblique face is upward tilted or downward tilted by comparing the oblique face with the plane. In one embodiment, if the calculated angle is bigger than 0 degree and smaller than 90 degrees, the processor determines the angle is within the specific range and the oblique face is downward tilted. On the other hand, if the angle is smaller than 0 degree or bigger than 90 degrees, the processor may determine the angle is outside the specific range and the oblique face is upward tilted.

If the processor determines that the angle is within the specific range after step S36, the processor then performs the compensation process on the color of each of the coloring points according to the angle (step S38). In particular, the processor compensates parts or all of the color printing information that related to each of the coloring points. More specific, the processor performs a deepened process to the color printing information that related to each of the coloring points.

According to the experiments, if the specific range is set within 0 degree to 90 degrees, the larger the oblique angle of the oblique face is (approaching to 90 degrees), the easier the printer 1 can perform the coloring actions. As a result, the compensation action performed by the processor to the coloring information of each coloring point in this scenario will be smaller (i.e., the criterion of the deepened process will be smaller). On the contrary, the smaller the oblique angle of the oblique face is (approaching to 0 degree), the harder the printer 1 can perform the coloring actions. As a result, the compensation action performed by the processor to the coloring information of each coloring point in this scenario will be larger (i.e., the criterion of the deepened process will be larger).

Each of the aforementioned color printing information respectively records Cyan information, Magenta information, Yellow information and Black information of each coloring point. In one embodiment, the processor performs the compensation process to the Cyan information of each coloring point according to a first formula, performs the compensation process to the Magenta information of each coloring point according to a second formula, performs the compensation process to the Yellow information of each coloring point according to a third formula, and performs the compensation process to the Black information of each coloring point according to a fourth formula. In the embodiment, the aforementioned four formulas may be exemplified as the following:

$$\text{First formula: } C' = a * C + b * t + c.$$

$$\text{Second formula: } M' = a * M + b * t + c.$$

$$\text{Third formula: } Y' = a * Y + b * t + c.$$

$$\text{Fourth formula: } K' = a * K + b * t + c.$$

According to the above four formulas, wherein "a", "b", "c" are respectively indicating compensation factors, "t" indicates the aforementioned oblique angle, "C" indicates the Cyan information, "C'" indicates the compensated Cyan information, "M" indicates the Magenta information, "M'" indicates the compensated Magenta information, "Y" indicates the Yellow information, "Y'" indicates the compensated Yellow information, "K" indicates the Black information, and "K'" indicates the compensated Black information.

The above compensation factors "a", "b", and "c" may be set according to the printing accuracy of the printer 1 to be used, and different printers may use different compensation factors.

In particular, the Cyan information, the Magenta information, the Yellow information and the Black information respectively record values within 0~100. When performing coloring on the slicing objects, the printer 1 controls the ink amount of Cyan ink, Magenta ink, Yellow ink and Black ink that jetted by the 2D nozzle 13 according to the Cyan information, the Magenta information, the Yellow information and the Black information of the corresponding image file. In one embodiment, the 2D nozzle 13 does not jet ink when the aforementioned value is recorded as 0, and the 2D nozzle 13 will jet maximum amount of ink when the aforementioned value is recorded as 100.

If the Cyan information, the Magenta information, the Yellow information and the Black information are recording the aforementioned value that within 0~100, then the above formulas may be modified as the following:

$$\text{First formula: } C' = \min(a * C + b * t + c, 100).$$

$$\text{Second formula: } M' = \min(a * M + b * t + c, 100).$$

$$\text{Third formula: } Y' = \min(a * Y + b * t + c, 100).$$

$$\text{Fourth formula: } K' = \min(a * K + b * t + c, 100).$$

According to the above four formulas, wherein "min" indicates to take the minimum value, "100" indicates the maximum amount corresponding to each color of ink jetted by the 2D nozzle 13 of the printer 1. In other words, the updated color information will not record a value exceeding the maximum amount of ink jetted by the 2D nozzle 13 of the printer 1.

By using the method of each embodiment disclosed in the present invention, the color of a downward tilted face of a 3D object may be effectively compensated, so as to make the color of a printed full-colored model more even and accuracy.

**Claims**

1. A method for compensating color of colored 3D object, comprising:

a) importing a 3D object (4) at a processor;

b) performing an object slicing process on the 3D object (4) for generating multiple object printing-route information of multiple printing layers;

c) performing an image slicing process on the 3D object (4) for generating multiple color printing information of the multiple printing layers;

d) performing a compensation process to the multiple color printing information for generating multiple updated color printing information, wherein each updated color printing information has been compensated on the color of an oblique face (5) of the 3D object (4), and an oblique angle (t) of the oblique face (5) is within a specific range; and

e) storing the multiple object printing-route information as multiple routing files at a storing unit, and storing the multiple updated color printing information as multiple image files at the storing unit.

2. The method in claim 1, wherein the specific range is bigger than 0 degree and smaller than 90 degrees.

3. The method in claim 1 or 2, wherein the processor regards any face of the 3D object (4) having a downward-oriented normal vector as the oblique face (5).

4. The method in any of the claims 1 to 3, wherein the step d further comprises following steps:

d1) obtaining a triangular face (51,52) related to each coloring point of the oblique face (5);

d2) obtaining a normal vector of the triangular face (51,52);

d3) calculating an angle between the triangular face (51,52) and a plane according to the normal vector, wherein the angle equals to the oblique angle (t) of the oblique face (5); and

d4) performing the compensation process to the color of each coloring point according to the calculated angle when the angle is within the specific range.

5. The method in any of the claims 1 to 4, wherein the normal vector is n(nx,ny,nz), and the angle is

$$\cos^{-1}\left(\frac{|nz|}{\sqrt{nx^2 + ny^2 + nz^2}}\right).$$

6. The method in any of the claims 4 to 5, wherein the color printing information respectively record Cyan information, Magenta information, Yellow information, and Black information of each coloring point.

7. The method in any of the claims 1 to 6, wherein the step d4 performs the compensation process to the color of each coloring point according to a first formula, a second formula, a third formula, and a fourth formula, wherein the first formula is: C'= a * C + b * t + c, the second formula is: M'= a * M + b * t + c, the third formula is: Y'= a * Y + b * t + c, and the fourth formula is: K'= a * K + b * t + c, wherein a, b, c indicates compensation factors, t indicates the calculated angle, C indicates the Cyan information, C' indicates a compensated Cyan information, M indicates the Magenta information, M' indicates a compensated Magenta information, Y indicates the Yellow information, Y' indicates a compensated Yellow information, K indicates the Black information, K' indicates a compensated Black information.

8. The method in claim 7, wherein the Cyan information, the Magenta information, the Yellow information, and the Black information respectively record values within 0 to 100, and the first formula is: C'=min(a * C + b * t + c , 100), the second formula is: M'=min(a * M + b * t + c , 100), the third formula is: Y'=min(a * Y + b * t + c , 100), and the fourth formula is : K'=min(a * K + b * t + c , 100).

9. The method in any of the claims 1 to 8, wherein further comprises following steps:

f) controlling a 3D nozzle (12) of a 3D printer (1) to print a slicing object of each of the printing layers layer by layer according to the multiple routing files; and

g) controlling a 2D nozzle (13) of the 3D printer (1) to perform coloring on the slicing object of each of the printing layers respectively according to the multiple image files.

10. The method in any of the claims 1 to 9, wherein the 3D printer (1) is a fused deposition modeling (FDM) type 3D printer.

1

11

14

12

13

FIG.1

FIG.2

FIG.3A

FIG.3B

# FIG.4

# FIG.5

```
                    ┌──────────┐
                    │  Start   │
                    └────┬─────┘
                         │
                         ▼
   ┌─────────────────────────────────────┐
   │ Obtaining triangular face related to each │ ⌐ S30
   │ coloring point                       │
   └─────────────────┬───────────────────┘
                     │
                     ▼
   ┌─────────────────────────────────────┐
   │ Obtaining normal vector of triangular face │ ⌐ S32
   └─────────────────┬───────────────────┘
                     │
                     ▼
   ┌─────────────────────────────────────┐
   │ Calculating angle between triangular face │ ⌐ S34
   │ and a plane according to normal vector │
   └─────────────────┬───────────────────┘
                     │        S36
                     ▼
              ◇─────────────────◇
       No     │ Is calculated angle within │
   ◄──────────┤    specific range?    │
              ◇─────────────────◇
                     │ Yes
                     ▼
   ┌─────────────────────────────────────┐
   │ Performing compensation process on the │
   │ color of each coloring point according to │ ⌐ S38
   │ calculated angle                     │
   └─────────────────┬───────────────────┘
                     │
                     ▼
                    ┌──────────┐
                    │   End    │
                    └──────────┘
```

# FIG.6

Europäisches
Patentamt

European
Patent Office

Office européen
des brevets

# EUROPEAN SEARCH REPORT

Application Number

EP 17 16 7583

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2016/132672 A1 (SEIKO EPSON CORP [JP]) 25 August 2016 (2016-08-25) * paragraphs [0031] - [0054], [0158] - [0192] * | 1-10 | INV. H04N1/58 B33Y10/00 B33Y50/02 |
| X | WO 2015/072155 A1 (SEIKO EPSON CORP [JP]) 21 May 2015 (2015-05-21) * paragraphs [0080] - [0087] * | 1-10 | |
| A | JP 2000 280354 A (MINOLTA CO LTD) 10 October 2000 (2000-10-10) * paragraphs [0106] - [0113]; figure 16 * | 1-10 | |
| A | WO 2015/163776 A1 (PLUCIENNIK TOMASZ [PL]; CHMIELEWSKI BRONISLAW [PL]; FUNKIEWICZ MARIA E) 29 October 2015 (2015-10-29) * the whole document * | 1-10 | |
|  |  |  | TECHNICAL FIELDS SEARCHED (IPC) |
|  |  |  | H04N B33Y B29C |

The present search report has been drawn up for all claims

| Place of search | Date of completion of the search | Examiner |
|---|---|---|
| The Hague | 11 October 2017 | Hardell, Alexander |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................
& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 17 16 7583

This annex lists the patent family members relating to the patent documents cited in the above-mentioned European search report.
The members are as contained in the European Patent Office EDP file on
The European Patent Office is in no way liable for these particulars which are merely given for the purpose of information.

11-10-2017

| Patent document cited in search report | | Publication date | Patent family member(s) | | Publication date |
|---|---|---|---|---|---|
| WO 2016132672 | A1 | 25-08-2016 | JP<br>WO | 2016150551 A<br>2016132672 A1 | 22-08-2016<br>25-08-2016 |
| WO 2015072155 | A1 | 21-05-2015 | JP<br>TW<br>WO | 2015098091 A<br>201520074 A<br>2015072155 A1 | 28-05-2015<br>01-06-2015<br>21-05-2015 |
| JP 2000280354 | A | 10-10-2000 | NONE | | |
| WO 2015163776 | A1 | 29-10-2015 | NONE | | |

EPO FORM P0459

For more details about this annex : see Official Journal of the European Patent Office, No. 12/82